# EUROPÄISCHE PATENTSCHRIFT

(11) **EP 0 996 972 B1**
(45) Veröffentlichungstag und Bekanntmachung des Hinweises auf die Patenterteilung: **29.05.2002**
(21) Anmeldenummer: 98944980.6
(22) Anmeldetag: 10.07.1998
(51) Int. Cl.: H01L 21/265, H01L 29/165

(54) **VERFAHREN ZUR GEZIELTEN HERSTELLUNG VON N-LEITENDEN BEREICHEN IN DIAMANTSCHICHTEN MITTELS IONENIMPLANTATION**
METHOD FOR TARGETED PRODUCTION ON N-TYPE CONDUCTIVE AREAS IN DIAMOND LAYERS BY ION IMPLANTATION
PROCEDE POUR LA REALISATION RATIONNELLE DE REGIONS A CONDUCTIVITE DE TYPE n DANS DES COUCHES EN DIAMANT PAR IMPLANTATION IONIQUE

(30) Priorität: 14.07.1997 DE 19730083
(43) Veröffentlichungstag der Anmeldung: 03.05.2000
(73) Patentinhaber: Forschungszentrum Rossendorf e.V., 01474 Schönfeld-Weissig (DE)
(72) Erfinder: HEERA, Viton, D-01279 Dresden (DE); SKORUPA, Wolfgang, D-01478 Weixdorf (DE)
(86) Internationale Anmeldenummer: DE9801928
(87) Internationale Veröffentlichungsnummer: WO9904418

(56) Entgegenhaltungen:
- US-A- 5 298 106
- FANG FANG ET AL: "OHMIC CONTACTS FORMED BY ION MIXING IN THE SI-DIAMOND SYSTEM" IEEE TRANSACTIONS ON ELECTRON DEVICES, Bd. 36, Nr. 9 - I, 1. September 1989, Seiten 1783-1786, XP000087136
- KALISH R: "Ion-implantation in diamond and diamond films: doping, damage effects and their applications" 2ND INTERNATIONAL SYMPOSIUM ON CONTROL OF SEMICONDUCTOR INTERFACES, KARUIZAWA, JAPAN, 28 OCT.-1 NOV. 1996, Bd. 117-118, Seiten 558-569, XP002087412 ISSN 0169-4332, Applied Surface Science, June 1997, Elsevier, Netherlands in der Anmeldung erwähnt
- PATENT ABSTRACTS OF JAPAN vol. 095, no. 008, 29. September 1995 -& JP 07 115191 A (KOBE STEEL LTD), 2. Mai 1995

## Beschreibung

Die Erfindung betrifft die Herstellung von Halbleiterbauelementen aus Diamanten, Diamantschichten und diamantähnlichen Schichten, die mittels Verfahren der Ionenimplantation dotiert werden und in die auch n-leitende Bereiche eingebracht werden.

Aus der Halbleitertechnik ist allgemein bekannt, Silizium und Siliziumkarbid mit Elementen der 5. Hauptgruppe mittels Ionenimplantation zu dotieren und so n-leitende Bereiche herzustellen. Die Bemühungen, dieses Verfahren für die Dotierung von Diamanten einzusetzen, verliefen nicht erfolgreich. Auch Alternativverfahren zur Dotierung mit z.B. Lithium oder Natrium führten nicht zu einem befriedigenden Ergebnis (R. Kalish, lon-implantation in diamond and diamond films: doping, damage effects and their applications, Applied Surface Science 117/118 (1997) 558).

Der Erfindung liegt die Aufgabe zugrunde, eine den jeweiligen Anforderungen an die n-Leitfähigkeit genügende Schicht in Diamanten, Diamantschichten und diamantähnlichen Schichten mittels Ionenimplantation zu gewährleisten.

Ansatzpunkt der Erfindung sind Diamanten, Diamantschichten und diamantähnliche Schichten, in die mittels Ionenimplantation Elemente der fünften Hauptgruppe eingebracht werden und die ausgeheilt werden. Ein solches Verfahren mit zusätzlicher Implantation von Kohlenstoff ist aus dem Dokument US-A-5 298 106 bekannt. Erfindungsgemäß wird nun zusätzlich zu den Elementen der fünften Hauptgruppe Silizium in den zu dotierenden lateralen und Tiefenbereich in einer Konzentration von mehr als 0,1 Atom% implantiert.
Dabei kann das Silizium vor oder nach dem Einbringen der Elemente der fünften Hauptgruppe in das Diamantsubstrat oder in einem Prozeßschritt mit diesen implantiert werden. Bei einer Siliziumimplantation nach dem Einbringen der Ionen der Elemente der fünften Hauptgruppe kann die Ausheilung nach jeder oder nur einmal nach der zweiten Implantation erfolgen.

Die Vorzüge bei der Anwendung der Erfindung bestehen darin, daß durch die vollständige oder teilweise Umwandlung von Diamantbereichen in Siliziumcarbid die tiefen Donatorzustände des Stickstoffes (E_{c}-1.7 eV) im Diamant zu flachen und damit elektrisch aktiven Donatorzuständen (E_{c}-0,08..0.14 eV) werden. Außerdem werden die durch Implantationsschäden verursachten graphitischen Anteile im Diamant, die seine halbleitenden Eigenschaften verschlechtern, reduziert. Es entstehen aufgrund der unterschiedlichen Bandlücken Hetero-pn-Übergänge zwischen den SiₓC₁₋ₓ- (3C-SiC: 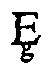 =2.3 eV) und Diamantbereichen_{g}(E =5.5 eV), die gegenüber Homo-pn-Übergängen eine Reihe von Vorteilen aufweisen, wie z. B. eine geringere Elektronen-Loch-Rekombinationsrate. Damit können in Bauelementen eine höhere Stromverstärkung und eine höhere Grenzfrequenz erreicht werden.

Die Erfindung wird nachstehend an zwei Ausführungsbeispielen näher erläutert.

### Ausführungsbeispiel 1:

Eine während des Abscheidens bordotierte p-leitende Diamantschicht mit einer Mindestdicke von 1 µm wird in einem Flächenbereich von 5 x 5 mm² bei einer Temperatur von 600 °C mit Siliziumionen (Ionenenergie 50 keV, lonendosis 1 x 10¹⁸ cm⁻²) zur Siliziumkarbid-Synthese und anschließend mit Stickstoffionen (Ionenenergie 20 keV, lonendosis 1 x 10¹⁵ cm⁻²) zur n-Dotierung implantiert. Nach Ausheilung der Probe für 10 min bei 1700 °C bildet sich im implantierten Bereich eine etwa 50 nm dicke n-dotierte Siliziumkarbid-Schicht mit einem Hetero-pn-Übergang zum Diamantsubstrat.

### Ausführungsbeispiel 2:

Ein natürlicher Diamant mit isolierenden Eigenschaften (Typ IIa) wird bei 1000 °C zunächst mit Borionen (Ionenenergie 50 keV, lonendosis 1 x 10¹⁶ cm⁻²), dann mit Stickstoffionen (Ionenenergie 30 keV, lonendosis 5 x 10¹⁵ cm⁻²) und Siliziumionen (Ionenenergie 50 keV, lonendosis 5 x 10¹⁷ cm⁻²) implantiert. Nach Ausheilung der Probe für 10 min bei 1700 °C bildet sich in einer Tiefe von etwa 50 nm ein pn-Übergang zwischen der teilweise in Siliziumkarbid umgewandelten n-leitenden Oberflächenschicht und der vergrabenen p-leitenden Schicht aus.

## Patentansprüche

1. Verfahren zur gezielten Herstellung von n-leitenden Bereichen in Diamanten, Diamantschichten und diamantähnlichen Schichten, in die Ionen der Elemente der fünften Hauptgruppe mittels Ionenimplantation eingebracht werden und bei denen das Diamant-Substrat ausgeheilt wird, wobei zusätzlich zu den Elementen der fünften Hauptgruppe Silizium in den zu dotierenden lateralen und Tiefen-Bereich in einer Konzentration von mehr als 0,1 Atom% implantiert und thermisch ausgeheilt wird.

2. Verfahren nach Anspruch 1, **dadurch gekennzeichnet, daß** die Elemente der fünften Hauptgruppe und das Silizium nacheinander eingebracht werden.

3. Verfahren nach Anspruch 1, **dadurch gekennzeichnet, daß** die Elemente der fünften Hauptgruppe und das Silizium gemeinsam in einem Ionenimplantationsprozeß eingebracht werden.

4. Verfahren nach Anspruch 1 und 2, **dadurch gekennzeichnet, daß** die thermische Ausheilung nach jeder Ionenimplantation durchgeführt wird.

5. Verfahren nach Anspruch 1 und 2, **dadurch gekennzeichnet, daß** die thermische Ausheilung nach der zweiten Ionenimplantation vorgenommen wird.

## Claims

1. Method for targeted production of n-type conductive areas in diamonds, diamond layers and diamond-like layers in which ions of the elements of the fifth main group are implanted by ion implantation and in which the diamond substrate is annealed, whereby in addition to the elements of the fifth group, silicon is implanted in the lateral and inner area to be dosed in a concentration of more than 0.1 atomic percent and thermally annealed.

2. Method according to claim 1, whereby the elements of the fifth main group and the silicon are implanted consecutively.

3. Method according to claim 1, whereby the elements of the fifth main group and the silicon are implanted together in one ion implantation process.

4. Method according to claims 1 and 2, whereby the thermal annealing is conducted after each ion implantation.

5. Method according to claims 1 and 2, whereby the thermal annealing is conducted after the second ion implantation.

## Revendications

1. Procédé pour la réalisation rationnelle de régions à conductivité de type n dans des diamants, des couches en diamant ou similaires au diamant, dans lesquels les ions des éléments du cinquième grand groupe sont introduits par implantation ionique et au cours desquels le substrat de diamant est consolidé et du silicium est implanté et thermiquement consolidé dans la région profonde et latérale à doper, avec une concentration d'atome de plus de 0,1 %, en plus des éléments du cinquième grand groupe.

2. Procédé selon la revendication 1, mais les éléments du cinquième grand groupe et le silicium sont introduits les uns après les autres.

3. Procédé selon la revendication 1, mais les éléments du cinquième grand groupe et le silicium sont introduits ensemble dans un processus d'implantation ionique.

4. Procédé selon les revendications 1 et 2, mais la consolidation thermique est réalisée après chaque implantation ionique.

5. Procédé selon les revendications 1 et 2, mais on procède à la consolidation thermique après la deuxième implantation ionique.
